# FASCICULE DE BREVET EUROPEEN

(11) **EP 3 629 385 B1**
(45) Date de publication et mention de la délivrance du brevet: **24.03.2021**
(21) Numéro de dépôt: 19199589.3
(22) Date de dépôt: 25.09.2019
(51) Int. Cl.: H01L 33/50, H01L 33/00, H01S 5/04, H01S 5/10, H01L 33/08, H01S 5/026, H01S 5/343, H01S 5/183, H01S 5/187, H01S 5/30

(54) **DISPOSITIF OPTOÉLECTRONIQUE ÉMETTEUR D'INFRAROUGE COMPORTANT UNE COUCHE ACTIVE À BASE D'ÉTAIN-GERMANIUM ET SON PROCÉDÉ DE FABRICATION**
OPTOELEKTRONISCHE INFRAROT-EMITTIERENDE VORRICHTUNG, DIE EINE AKTIVE SCHICHT AUF GERMANIUM-ZINN-BASIS UMFASST, UND HERSTELLUNGSVERFAHREN DAFÜR
OPTOELECTRONIC INFRARED-EMITTING DEVICE COMPRISING AN ACTIVE LAYER BASED ON GERMANIUM-TIN AND METHOD FOR MANUFACTURING THE SAME

(30) Priorité: 28.09.2018 FR 1858948
(43) Date de publication de la demande: 01.04.2020
(73) Titulaire: Commissariat à l'Énergie Atomique et aux Énergies Alternatives, 75015 Paris (FR)
(72) Inventeur: REBOUD, Vincent, 38054 GRENOBLE CEDEX 9 (FR); TCHELNOKOV, Alexei, 38054 GRENOBLE CEDEX 9 (FR); WIDIEZ, Julie, 38054 GRENOBLE cedex 9 (FR)
(74) Mandataire: INNOV-GROUP

(56) Documents cités:
- WO-A2-03/050887
- FR-A1- 3 041 812
- US-A1- 2015 014 632
- REBOUD V ET AL: "Optically pumped GeSn micro-disks with 16% Sn lasing at 3.1[mu]m up to 180 K", APPLIED PHYSICS LETTERS, A I P PUBLISHING LLC, US, vol. 111, no. 9, 28 août 2017 (2017-08-28) , XP012221658, ISSN: 0003-6951, DOI: 10.1063/1.5000353 [extrait le 2017-08-28]
- THAI Q M ET AL: "Lasing Effect in GeSn Photonic Crystal", 2018 IEEE 15TH INTERNATIONAL CONFERENCE ON GROUP IV PHOTONICS (GFP), IEEE, 29 août 2018 (2018-08-29), pages 1-2, XP033413367, DOI: 10.1109/GROUP4.2018.8478701

## Description

### DOMAINE TECHNIQUE

Le domaine de l'invention est celui de la fabrication des dispositifs optoélectroniques d'émission de lumière infrarouge, et plus particulièrement de lumière du moyen infrarouge (MWIR, pour *Middle Wave InfraRed,* en anglais), comportant une couche active à base de germanium étain GeSn.

### ÉTAT DE LA TECHNIQUE ANTÉRIEURE

Les dispositifs optoélectroniques d'émission de lumière infrarouge peuvent comporter une couche optiquement active réalisée à base d'un composé semiconducteur cristallin de la colonne IV du tableau périodique des éléments, par exemple un alliage à base de germanium étain GeSn. La couche est dite active dans la mesure où elle génère l'essentiel du rayonnement lumineux infrarouge émis par le dispositif optoélectronique. Le germanium étain Ge₁₋ₓSnₓ peut en effet présenter une structure de bandes d'énergie directe propice à l'émission du rayonnement lumineux infrarouge lorsque la proportion atomique d'étain x_{Sn} est suffisante.

La réalisation de telle couche active à base de GeSn reste cependant délicate, du fait notamment de la différence importante entre le paramètre de maille du germanium (a_{Ge}=5,658Å) et celui de l'étain (a_{Sn}=6,489Å), et de la différence entre la température de fusion du germanium (950°C environ) et celle de l'étain (240°C environ) qui peut conduire à une démixtion de l'étain.

Dans le but de fabrication un tel dispositif optoélectronique, une approche consiste à réaliser une couche active de GeSn partiellement relaxé par croissance épitaxiale, à partir d'un pseudo-substrat (*virtual-substrate,* en anglais) de germanium. A ce titre, la publication de Wirths et al. intitulée Lasing in direct-bandgap GeSn alloy grown on Si, Nature Photon. 9, 88-92 (2015) décrit un procédé de fabrication d'un dispositif optoélectronique dans lequel une couche active en germanium étain GeSn est réalisée par croissance épitaxiale de type CVD à partir d'une couche de nucléation en germanium Ge quasi-relaxé formé sur un substrat de silicium Si. Une couche active épaisse en germanium étain GeSn est formée par épitaxie à partir de la couche de nucléation, et présente une épaisseur suffisante pour que les contraintes mécaniques relaxent plastiquement et que le germanium étain, sur au moins une épaisseur de la couche active, est quasi-relaxé. Aussi, la couche active ainsi réalisée présente une relative bonne qualité cristalline, hormis à l'interface avec la couche de nucléation où la relaxation plastique des contraintes mécaniques a généré des défauts structuraux de type dislocations. Les auteurs montrent qu'une proportion atomique d'étain de 12,6% permet de rendre directe la structure de bandes d'énergie dans une couche de GeSn relaxé et ainsi d'émettre un rayonnement lumineux infrarouge.

Une autre approche consiste à réaliser une couche active à base de GeSn subissant des contraintes mécaniques en tension dans le plan de la couche. En effet, comme le montre notamment la publication de Wirths et al. intitulée Strain Engineering for Direct Bandgap GeSn Alloys, IEEE 11th International Conférence On Group IV Photonics, 2014, la proportion atomique minimale d'étain x_{Sn} présent dans la couche active à base de GeSn dépend du type de contraintes mécaniques subies par la couche active (compression, tension) et de leur intensité. Aussi, la diminution de cette proportion atomique minimale d'étain x_{Sn} permet de réduire les risques de démixtion de l'étain. A ce titre, la demande internationale WO 2018/037189 A1 décrit un procédé de fabrication d'un dispositif optoélectronique d'émission lumineuse infrarouge par une couche active à base de GeSn, celle-ci étant obtenue sous la forme d'une membrane suspendue au-dessus d'un substrat et mise en tension par des bras tenseurs, puis assemblée par collage direct au substrat par effondrement de la membrane La demande française FR 3 041 812 A1 décrit également un procédé de fabrication d'un dispositif optoélectronique pouvant intrinsèquement émettre dans l'infrarouge; procédé impliquant la formation d'une portion semiconductrice en GeSn par croissance épitaxiale sur une portion contrainte de germination en germanium.

### EXPOSÉ DE L'INVENTION

L'invention a pour objectif de remédier au moins en partie aux inconvénients de l'art antérieur, et plus particulièrement de proposer un procédé de fabrication d'un dispositif optoélectronique d'émission de lumière infrarouge, qui comporte une couche active à base de GeSn de bonne qualité cristalline, qu'il soit quasi-relaxé ou contraint en tension, et qui permette en outre de limiter les risques de démixtion de l'étain contenu dans la couche active.

Pour cela, l'objet de l'invention est un procédé de fabrication, selon la revendication 1 en annexe, d'un dispositif optoélectronique d'émission d'un rayonnement lumineux infrarouge, comportant les étapes suivantes :
i) réalisation d'un premier empilement comportant :
   - une source lumineuse d'un rayonnement lumineux d'excitation,
   - une première sous-couche de collage réalisée en un matériau métallique d'intérêt choisi parmi l'or, le titane et le cuivre, présentant une première face de contact,
   - entre lesquelles est disposée une première couche de liaison réalisée en un matériau transparent au rayonnement lumineux d'excitation ;
ii) réalisation d'un deuxième empilement comportant :
   - une couche active à base de GeSn, obtenue par croissance épitaxiale à une température d'épitaxie, et adaptée à absorber le rayonnement lumineux d'excitation et à émettre en réponse le rayonnement lumineux infrarouge,
   - une deuxième sous-couche de collage réalisée en ledit matériau métallique d'intérêt, présentant une deuxième face de contact,
   - entre lesquelles est disposée une deuxième couche de liaison réalisée en un matériau transparent au rayonnement lumineux d'excitation ;
iii) détermination d'une température d'assemblage comprise entre une température ambiante et ladite température d'épitaxie, telle qu'une énergie surfacique de collage direct dudit matériau métallique d'intérêt est supérieure ou égale à 0,5J/m²;
iv) assemblage par collage direct, à ladite température d'assemblage, desdits empilements au niveau desdites faces de contact.

La couche active à base de GeSn présente une proportion atomique d'étain telle qu'elle, ou plus précisément le matériau à base de GeSn de la couche active, présente une structure de bandes d'énergie directe.

Certains aspects préférés mais non limitatifs de ce procédé sont les suivants.

Le procédé de fabrication peut comporter :
- une phase de structuration en épaisseur de la première sous-couche de collage et/ou de la deuxième sous-couche de collage, de sorte que la couche intermédiaire métallique formée par lesdites sous-couches de collage assemblées l'une à l'autre comporte au moins un réseau périodique, la couche intermédiaire métallique présentant une épaisseur minimale non nulle ;
- une phase de détermination, préalable à la phase de structuration, de paramètres géométriques du réseau périodique, de sorte que la couche intermédiaire métallique présente un coefficient de transmission du rayonnement lumineux d'excitation d'une valeur supérieure à une valeur prédéterminée correspondant à une couche intermédiaire métallique équivalente sans réseau périodique, plane et d'une épaisseur constante égale à ladite épaisseur minimale.

Le réseau périodique peut être situé à l'interface avec la première et/ou la deuxième couches de liaison, lesdites faces de contact étant planes.

La couche intermédiaire métallique peut comporter au moins une partie continue d'une première épaisseur constante égale à l'épaisseur minimale, et des plots agencés en saillie vis-à-vis de la partie continue et formant le réseau périodique.

La source lumineuse d'excitation peut être une diode électroluminescente ou une source laser à cavité verticale émettant par la surface.

La source lumineuse d'excitation peut être une source laser à cavité verticale émettant par la surface comportant un réflecteur inférieur et un réflecteur supérieur entre lesquels est disposé un milieu à gain, le réflecteur supérieur étant au contact et recouvert par la première couche de liaison. Le procédé peut alors comporter :
- une phase de détermination, préalable à la phase de réalisation du premier empilement, d'une épaisseur de la première couche de liaison, de sorte qu'un réflecteur équivalent formé par le réflecteur supérieur et par la couche intermédiaire métallique, séparés l'un de l'autre par la première couche de liaison, présente un coefficient de réflexion du rayonnement lumineux d'excitation d'une valeur supérieure à une valeur prédéterminée.

La température d'assemblage peut être inférieure ou égale à la température d'épitaxie, à 10% près.

Le matériau transparent des couches de liaison peut être un matériau diélectrique.

Le matériau transparent des couches de liaison peut être à base de silicium.

Les deux sous-couches de collage assemblées l'une à l'autre forment une couche intermédiaire métallique pouvant présenter une épaisseur moyenne comprise entre 5nm et 40nm.

Le procédé de fabrication peut comporter une étape de structuration de la couche active à base de GeSn, de manière à former une cavité résonante orientée dans le plan de la couche active, c'est-à-dire qu'un mode optique peut se propager dans la cavité résonante dans le plan de la couche active.

L'invention porte également sur un dispositif optoélectronique d'émission d'un rayonnement lumineux infrarouge, selon la revendication 12 en annexe, comportant un empilement de :
- une source lumineuse d'un rayonnement lumineux d'excitation ;
- une première sous-couche de collage réalisée en un matériau métallique d'intérêt choisi parmi l'or, le titane et le cuivre, présentant une première face de contact ;
- une première couche de liaison réalisée en un matériau transparent au rayonnement lumineux d'excitation, disposée entre la source lumineuse et la première sous-couche de collage ;
- une deuxième sous-couche de collage réalisée en ledit matériau métallique d'intérêt, présentant une deuxième face de contact assemblée et au contact de la première face de contact ;
- une couche active à base de GeSn, présentant une proportion atomique d'étain telle qu'elle présente une structure de bandes d'énergie directe, et étant adaptée à absorber le rayonnement lumineux d'excitation et à émettre en réponse le rayonnement lumineux infrarouge ;
- une deuxième couche de liaison réalisée en un matériau transparent au rayonnement lumineux d'excitation, disposée entre la couche active et la deuxième sous-couche de collage.

La première sous-couche de collage et/ou la deuxième sous-couche de collage peuvent présenter une structuration en épaisseur de sorte que la couche intermédiaire métallique, formée par lesdites sous-couches de collage assemblées l'une à l'autre, comporte au moins un réseau périodique et présente une épaisseur minimale non nulle. Le réseau périodique peut être défini par des paramètres géométriques tels que la couche intermédiaire métallique présente un coefficient de transmission du rayonnement lumineux d'excitation d'une valeur supérieure à une valeur correspondant à une couche intermédiaire métallique équivalente sans réseau périodique, plane et d'une épaisseur constante égale à ladite épaisseur minimale.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1D sont des vues en coupe transversale, schématiques et partielles, de structures obtenues à différentes étapes d'un procédé de fabrication d'un dispositif optoélectronique d'émission lumineuse infrarouge selon un mode de réalisation ;
les figures 2A et 2B sont des vues en coupe transversale, schématiques et partielles, d'un dispositif optoélectronique obtenu par un procédé de fabrication selon un autre mode de réalisation, la fig.2B illustrant une partie du dispositif optoélectronique illustré sur la fig.2A ;
les figures 3A-3B et 4A-4B illustrent des exemples d'évolution du coefficient de transmission T associé à la couche intermédiaire métallique du dispositif optoélectronique illustré sur la fig.2A, en fonction de paramètres géométriques du réseau périodique qu'elle comporte ;
la figure 5A est une vue en coupe transversale, schématique et partielle, d'une partie du dispositif optoélectronique illustré sur la fig.2A, illustrant la distance d séparant la couche intermédiaire métallique d'un miroir supérieur d'une source VCSEL ; et les figures 5B et 5C illustrent des exemples d'évolution du coefficient de réflexion R d'un miroir équivalent formé par le miroir supérieur et la couche intermédiaire métallique, en fonction de la distance d.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un dispositif optoélectronique d'émission de lumière infrarouge comportant une couche active à base de germanium étain GeSn à haute qualité cristalline, disposée en regard d'une source lumineuse d'un rayonnement lumineux d'excitation. Le dispositif optoélectronique peut être un dispositif d'émission de lumière incohérente ou de lumière cohérente. La lumière émise est située dans la gamme spectrale infrarouge, et plus précisément dans la gamme spectrale du moyen infrarouge (longueur d'onde centrale λ₂ comprise de préférence entre 2µm et 6µm environ). Le procédé de fabrication comporte une étape d'assemblage par collage direct de deux empilements distincts, l'un comportant la source lumineuse d'excitation, et l'autre comportant la couche active à base de GeSn.

Par couche active à base de germanium étain GeSn, on entend une couche réalisée en un composé semiconducteur cristallin GeSn comprenant au moins du germanium et de l'étain, adaptée à absorber le rayonnement lumineux incident d'une première longueur d'onde centrale λ₁ émis par la source lumineuse d'excitation, et à émettre en réponse un rayonnement lumineux à une deuxième longueur d'onde centrale λ₂, supérieure à λ₁. L'alliage de germanium étain peut être un alliage binaire Ge₁₋ₓSnₓ, un alliage ternaire, par exemple Si_{y}Ge_{1-x-y}Snₓ, voire un alliage quaternaire ou plus. On note x_{Sn} la proportion atomique d'étain contenu dans l'alliage. La couche active à base de germanium étain est de préférence formée en un alliage homogène en termes de proportion atomique des éléments formant l'alliage, ainsi qu'en termes de valeurs d'un éventuel dopage.

Par collage direct (*direct bonding,* en anglais), parfois également appelé collage moléculaire ou collage par adhérence moléculaire, on entend la solidarisation de deux surfaces de matériaux identiques ou différents, l'une contre l'autre, sans apport de couche collante spécifique (de type colle, glue, etc...) mais par le biais des forces attractives d'interaction atomique ou moléculaire entre les surfaces à coller, par exemple des forces de Van der Walls, des liaisons hydrogènes, voire des liaisons covalentes. L'assemblage des empilements par collage direct peut être assisté en température (via une phase supplémentaire de recuit) et/ou en pression. La structure formée des deux empilements présente alors une énergie de collage qui, au premier ordre, peut s'écrire : Ec ∼ EsxS, où Eₛ est l'énergie surfacique de collage du matériau des surfaces à coller (on suppose ici que les surfaces à coller présentent des énergies de surface sensiblement égales) et S est l'étendue des surfaces collées. L'énergie surfacique de collage peut être mesurée par la technique d'insertion de lame dite 'méthode de la lame de Mazara' : lors de l'insertion de la lame, on mesure la distance de décollement qui est proportionnelle à l'énergie surfacique de collage.

Le germanium étain GeSn est destiné à présenter une structure de bandes d'énergie directe, c'est-à-dire que le minimum d'énergie de la vallée L (ou vallée indirecte) est supérieur ou sensiblement égal au minimum d'énergie de la vallée Γ (ou vallée directe) de la bande de conduction, autrement dit : ΔE = E_{min,L}-E_{min,Γ} ≥ 0. Par sensiblement égal, on entend ici que cette différence d'énergie ΔE est de l'ordre de grandeur ou inférieure à kT, où k est la constante de Boltzmann et T la température du matériau. La différence d'énergie ΔE dépend de la proportion atomique d'étain x_{Sn}, laquelle est notamment fonction de l'état de contrainte mécanique de la couche active. Ainsi, la proportion atomique d'étain x_{Sn} minimale pour rendre directe la structure de bandes d'énergie diminue à mesure qu'augmente la contrainte mécanique en tension subie par la couche active (cf. Wirths et al. 2014 mentionné précédemment). La couche active à base de GeSn est contrainte en tension dans le plan de la couche lorsque son paramètre de maille présente une valeur effective supérieure à sa valeur dite naturelle lorsque le composé GeSn est relaxé, i.e. non contraint. Dans le cadre de l'invention, la couche active à base de GeSn peut être relaxée (ou quasi-relaxée), voire présenter une contrainte en tension. Elle comporte une proportion atomique d'étain x_{Sn} suffisante pour que sa structure de bandes d'énergie soit directe.

La source lumineuse d'excitation peut être une source laser à cavité verticale émettant par la surface (VCSEL) mais peut également être une diode électroluminescente. On utilisera l'acronyme VCSEL dans la suite de la description. La source lumineuse d'excitation est réalisée à base de composés semiconducteurs, par exemple à base de composés III-V, lesquels sont des alliages comportant au moins un élément de la colonne III et au moins un élément de la colonne V du tableau périodique. Les composés semiconducteurs de la source lumineuse d'excitation peuvent être, par exemple, de l'InP et du GaAs. Par « à base de », on entend que la couche ou la structure comporte majoritairement le ou les composés semiconducteurs en question, c'est-à-dire qu'au moins 50% de son volume est formé ou comporte les composés semiconducteurs en question.

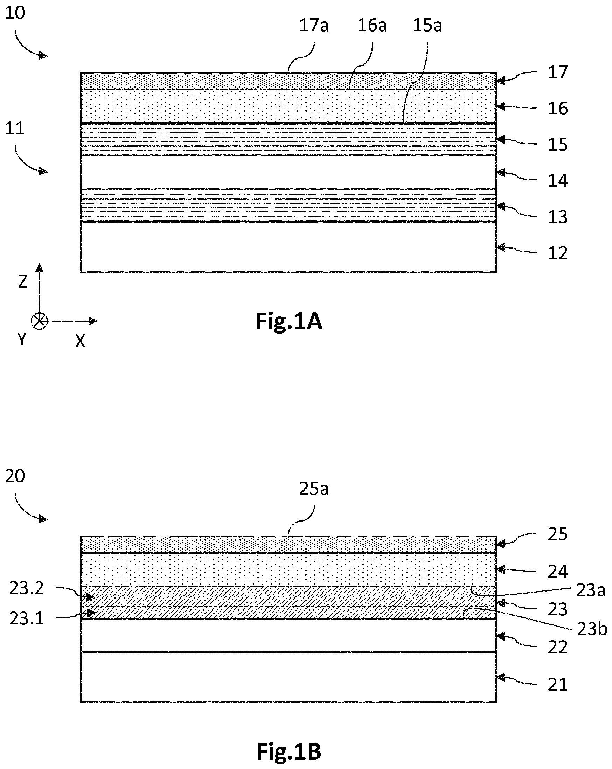

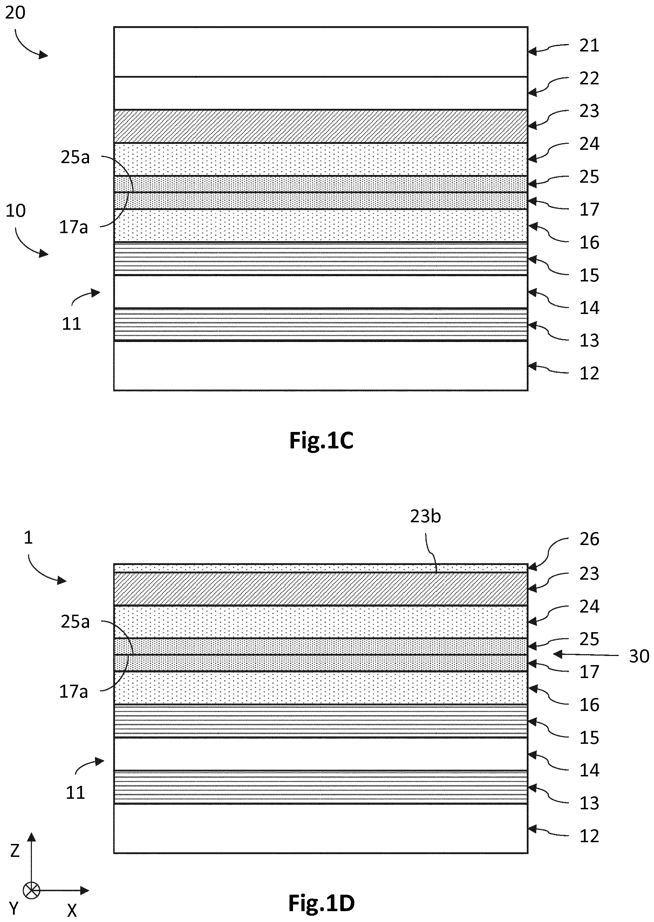

Les figures 1A à 1D sont des vues schématiques et partielles, en coupe transversale, d'un dispositif optoélectronique 1 d'émission de lumière infrarouge à différentes étapes d'un procédé de fabrication selon un mode de réalisation. Dans cet exemple, le dispositif optoélectronique 1 comporte une couche active 23 à base de germanium étain GeSn adaptée à émettre un rayonnement de lumière incohérente dans le moyen infrarouge, en réponse à l'absorption d'un rayonnement lumineux incident émis par la source lumineuse d'excitation 11, ici une source VCSEL. De plus, le composé cristallin à base à germanium étain GeSn de la couche active 23 est ici quasi-relaxé.

On définit ici et pour la suite de la description un repère direct tridimensionnel (X,Y,Z), où les axes X et Y forment un plan parallèle au plan d'un substrat support 12 sur lequel repose la source VCSEL, et où l'axe Z est orienté suivant l'épaisseur des couches. Dans la suite de la description, les termes « vertical » et « verticalement » s'entendent comme étant relatifs à une orientation sensiblement parallèle à l'axe Z. Par ailleurs, les termes « inférieur » et « supérieur » s'entendent comme étant relatifs à un positionnement croissant lorsqu'on s'éloigne de la couche support suivant la direction +Z.

En référence à la figure 1A, on réalise un premier empilement 10 formé d'au moins une source VCSEL d'excitation 11, revêtue d'une première couche de liaison 16, puis d'une première sous-couche de collage 17 définissant une face plane de contact 17a.

La source lumineuse 11 est adaptée à émettre un rayonnement lumineux d'excitation à une première longueur d'onde centrale λ₁, c'est-à-dire que le spectre d'émission de la source lumineuse 11 présente un pic d'intensité centré sur la longueur d'onde λ₁, laquelle est inférieure à la longueur d'onde d'émission λ₂ du dispositif optoélectronique 1. Dans cet exemple, il s'agit d'une source VCSEL 11 réalisée à base de composés semiconducteurs III-V dont la longueur d'onde λ₁ est située dans le visible ou le proche infrarouge.

Dans cet exemple, le premier empilement 10 comporte un substrat support 12 comportant un circuit électrique permettant la commande de la source VCSEL 11. Il peut comporter à cet effet des composants électroniques actifs (transistors, condensateurs, résistances...) connectés à la source VCSEL 11 par des interconnexions électriques (non représentées). En variante, le substrat support 12 peut ne pas comporter le circuit électrique de commande, mais peut comporter des interconnexions électriques adaptées à assurer la polarisation électrique de la source VCSEL 11 avec une puce de commande rapportée (non représentée) à laquelle le substrat support 12 serait connecté.

La source VCSEL d'excitation 11 comporte une cavité résonante de type Fabry-Pérot délimitée par deux réflecteurs, ici deux miroirs de Bragg 13, 15, et un milieu à gain 14 situé dans la cavité résonante. Elle est adaptée à générer un rayonnement lumineux de longueur d'onde centrale λ₁, celle-ci étant définie au premier ordre par la dimension de la cavité résonante et par l'indice de réfraction des composés semiconducteurs qui la forment. A titre d'exemple, la longueur d'onde λ₁ peut être située dans le visible ou dans le proche infrarouge, par exemple peut être égale à 980nm environ, voire à 1300nm environ. Les miroirs de Bragg 13, 15 sont formés d'une alternance de couches semiconductrices quart d'onde ayant respectivement un indice de réfraction élevé et un indice de réfraction faible. Les couches semiconductrices quart d'onde peuvent être réalisées, à titre purement illustratif, à partir des composés semiconducteurs GaAs et AlAs, et de leurs alliages. Ainsi, les couches semiconductrices quart d'onde peuvent être réalisées en GaAs et en AlGaAs. L'indice de réfraction du AlAs est de 2,9 dans le domaine du proche infrarouge et celui du GaAs est de 3,5. Le composé semiconducteur AlₓGa₁₋ₓAs présente ainsi un indice de réfraction compris entre 2,9 et 3,5 en fonction de la teneur x d'aluminium. Le nombre de couches semiconductrices quart d'onde est suffisant pour obtenir une réflectivité élevée des miroirs de Bragg 13, 15 à la longueur d'onde λ₁, par exemple de l'ordre de 99,9%. Cette réflectivité est bien plus élevée que dans le cas d'une source laser de type ruban, dans la mesure où dans une source VCSEL, le gain du milieu amplificateur est faible puisque le rayonnement lumineux le traverse de manière perpendiculaire. Dans cet exemple, la source VCSEL 11 comporte un miroir de Bragg inférieur 13 réalisé en GaAs/AlGaAs et reposant sur le substrat support 12 ; un milieu à gain 14 formé de plusieurs puits quantiques ici en InGaAs ; et un miroir de Bragg supérieur 15 réalisé en GaAs/AlGaAs. De plus, le miroir de Bragg inférieur 13 peut être dopé selon un premier type de conductivité, par exemple de type n, et le miroir de Bragg supérieur 15 peut être dopé selon un second type de conductivité opposé au premier type, ici de type p.

Le premier empilement 10 comporte une première couche de liaison 16, qui revêt continûment la face supérieure 15a du miroir de Bragg supérieur 15 de la source VCSEL, et assure la liaison entre la source VCSEL 11 et la première sous-couche de collage 17. Elle est réalisée en un matériau transparent au rayonnement lumineux d'excitation, c'est-à-dire que le coefficient de transmission du rayonnement d'excitation associé à la première couche de liaison 16 est supérieur ou égal à 50%, et de préférence supérieur. Le matériau transparent peut être un matériau diélectrique, et être un matériau à base de silicium, tel que, par exemple, un oxyde de silicium (par ex. SiO₂) ou un nitrure de silicium (par ex. Si₃N₄), voire un oxynitrure de silicium, ou encore du silicium amorphe intrinsèque (non intentionnellement dopé). Il peut également être un oxyde d'aluminium (par ex. Al₂O₃) ou un oxyde d'hafnium (par ex. HfO₂). L'épaisseur moyenne de la couche de liaison 16 peut être comprise entre quelques nanomètres et quelques microns, de préférence est comprise entre 50nm et µm. La couche de liaison 16 peut présenter une épaisseur constante ou non dans le plan de la couche, selon qu'elle est structurée en épaisseur ou non.

Le premier empilement 10 comporte également une première sous-couche de collage 17, qui revêt continûment la face supérieure 16a de la couche de liaison 16. Elle est destinée à être assemblée par collage direct à la deuxième sous-couche de collage 25 du deuxième empilement 20. Elle est réalisée en un matériau métallique d'intérêt choisi parmi l'or Au, le cuivre Cu et le titane Ti. De tels matériaux présentent une énergie surfacique de collage Eₛ supérieure ou égale à 0,5 J/m² à une température T_{c} dite d'assemblage, c'est-à-dire à une température sensiblement comprise entre la température ambiante T_{amb} et la température d'épitaxie Tₑₚᵢ de la couche active 23 à base de GeSn. L'épaisseur moyenne de la première sous-couche de collage 17 peut être comprise entre quelques nanomètres et dizaines de nanomètres, par exemple est comprise entre 2nm et 20nm, et de préférence est comprise entre 5nm et 10nm. La sous-couche de collage 17 peut présenter une épaisseur constante ou non dans le plan de la couche, selon qu'elle est structurée en épaisseur ou non. Selon un mode de réalisation, elle présente une épaisseur constante dans le plan XY de la couche. Selon une variante avantageuse, comme décrit en détail plus loin, elle présente une structuration en épaisseur, périodique suivant une ou deux dimensions dans le plan XY de la couche. Elle présente une face supérieure dite de contact 17a, sensiblement plane, destinée à être mise au contact de la face plane de contact 25a du deuxième empilement 20.

En référence à la figure 1B, on réalise un deuxième empilement 20 formé d'au moins la couche active 23 à base de GeSn, revêtue d'une deuxième couche de liaison 24, puis d'une deuxième sous-couche de collage 25 définissant la face plane de contact 25a. La couche active 23 est formée ici d'un alliage binaire de germanium étain Ge₁₋ₓSnₓ réalisé par croissance épitaxiale à partir d'une couche de nucléation 22 disposée sur un substrat de croissance 21.

Le substrat de croissance 21 peut être réalisé en un matériau semiconducteur, électriquement conducteur ou diélectrique. Ce matériau peut présenter une épaisseur de l'ordre de quelques dizaines de nanomètres à quelques centaines de microns, par exemple être comprise entre 10nm et 750µm, voire comprise entre 500nm et 100µm. Il est ici réalisé en silicium, mais il peut plus généralement être choisi, entre autres, parmi le silicium, le saphir, le borosilicate, la silice, le verre, le quartz.

La couche de nucléation 22 peut être réalisée en un matériau semiconducteur monocristallin adapté à la nucléation, ou germination, de la couche active 23 à base de GeSn. Le matériau de la couche de nucléation 22 peut être choisi parmi les éléments ou composés de la colonne IV de la classification périodique, tel que le germanium, le silicium, l'étain, et les alliages formés de ces éléments tels que GeSn, SiGeSn, SiGe. Il peut également être choisi parmi les composés comportant des éléments des colonnes III et V, tels que GaP, AlP, AlAs, InGaAs, InP, AlGas, voire parmi les composés comportant des éléments des colonnes II et VI, tels que ZnS, ZnSe, CdZnTe, CdTe. Il s'agit ici de germanium. Dans cet exemple, la couche de nucléation 22 est une couche épaisse dans le sens où son épaisseur est supérieure à l'épaisseur critique à partir de laquelle les contraintes mécaniques subies par la couche relaxent plastiquement.

La couche active 23 à base de GeSn est ensuite réalisée par croissance épitaxiale à partir de la couche de nucléation 22, à une température d'épitaxie Tₑₚᵢ. Elle peut être formée par des techniques de dépôt chimique en phase vapeur (CVD, pour *Chemical Vapor Deposition* en anglais), telles que le dépôt chimique à basse pression (RPCVD, pour *Reduced Pressure Chemical Vapor Deposition*), le dépôt chimique en phase vapeur organométallique (MOCVD, pour *Metal-Organic Chemical Vapor Deposition*), le dépôt chimique en phase vapeur assisté par plasma (PECVD, pour *Plasma-Enhanced Chemical Vapor Deposition*), l'épitaxie en phase vapeur aux hydrures (HVPE, pour *Hydride Vapor Phase Epitaxy*), voire également la pulvérisation cathodique réactive (*sputtering* en anglais). Des techniques telles que l'épitaxie par jets moléculaires (MBE, pour *Molecular-Beam Epitaxy*) ou l'épitaxie en phase liquide (LPE, pour *Liquid Phase Epitaxy*) peuvent également être utilisées. Par température d'épitaxie Tₑₚᵢ, on entend la température minimale imposée au substrat de croissance 21 dans l'enceinte du bâti d'épitaxie conduisant à la croissance de la couche active 23. La température d'épitaxie Tₑₚᵢ dépend notamment du type de substrat de croissance utilisé (conductivité thermique, épaisseur...), et de la proportion atomique d'étain x_{Sn} que l'on souhaite incorporer dans la couche active 23. Ainsi, la température d'épitaxie Tₑₚᵢ d'une couche active 23 de GeSn ayant une proportion atomique d'étain x_{Sn} égale à 6%, 8%, 10%, 13% et 16% environ peut être égale respectivement à 349°C, 337°C, 325°C, 313°C, 301°C environ (ici pour une couche de nucléation de 2,5µm de germanium épitaxié sur un substrat de silicium). Elle peut comporter une zone dopée n et une zone dopée p, entre lesquelles est disposée une zone active comportant un ou plusieurs puits quantiques.

Dans cet exemple, la couche active 23 est une couche épaisse, dans le sens où son épaisseur est supérieure à son épaisseur critique de relaxation plastique des contraintes mécaniques, de sorte qu'elle présente une première zone 23.1 contrainte en compression située au contact de la couche de nucléation 22 en germanium, qui peut alors comporter des défauts structuraux de type dislocations, surmontée d'une deuxième zone 23.2 quasi-relaxée ne comportant sensiblement pas de défauts structuraux. En effet, dans cette deuxième zone 23.2, le paramètre de maille effectif de la couche active 23 est sensiblement égal à sa valeur à l'état naturel. Cela se traduit alors par une bonne relaxation des contraintes mécaniques dans la couche active 23 suivant son épaisseur. La forte épaisseur de la couche active 23 conduit ainsi à une réduction de la densité de défauts structuraux tels que les dislocations de désaccord de maille. Par ailleurs, la couche active 23 en germanium étain GeSn quasi-relaxé présente avantageusement une proportion atomique d'étain x_{Sn} permettant de rendre directe la structure de bandes d'énergie, par exemple supérieure ou égale à 10%. Enfin, la couche active 23 présente ici une épaisseur constante, et comporte deux faces sensiblement planes, une première face 23b au contact de la couche de nucléation 22, et une deuxième face 23a revêtue par une deuxième couche de liaison 24.

Le deuxième empilement 20 comporte une deuxième couche de liaison 24, qui revêt continûment la deuxième face 23a de la couche active 23 à base de GeSn, et assure la liaison entre celle-ci et la deuxième sous-couche de collage 25. Elle est réalisée en un matériau transparent au rayonnement lumineux d'excitation et au rayonnement lumineux émis par la couche active 23 et de préférence diélectrique, et avantageusement identique à celui de la première couche de liaison 16. L'épaisseur moyenne de la couche de liaison 24 peut être comprise entre quelques nanomètres et quelques microns, de préférence est comprise entre 50nm et µm. La couche de liaison 24 peut présenter une épaisseur constante ou non dans le plan de la couche, selon qu'elle est structurée en épaisseur ou non.

Le deuxième empilement 20 comporte également une deuxième sous-couche de collage 25, qui revêt continûment la couche de liaison 24. Elle est destinée à être assemblée par collage direct à la première sous-couche de collage 17 du premier empilement 10. Elle est réalisée en le même matériau métallique d'intérêt que la première sous-couche de collage 17, c'est-à-dire qu'il est choisi parmi l'or, le cuivre et le titane. L'épaisseur moyenne de la sous-couche de collage 25 peut être comprise entre quelques nanomètres et dizaines de nanomètres, par exemple est comprise entre 2nm et 20nm, et de préférence est comprise entre 5nm et 10nm. La sous-couche de collage 25 peut présenter une épaisseur constante ou non dans le plan de la couche, selon qu'elle est structurée en épaisseur ou non. Selon un mode de réalisation, elle peut ainsi présenter une épaisseur constante dans le plan XY de la couche. Selon une variante avantageuse, comme décrit en détail plus loin, elle présente une structuration en épaisseur, périodique suivant une ou deux dimensions dans le plan XY de la couche. Elle présente une face dite de contact 25a, sensiblement plane, destinée à être mise au contact de la face de contact 17a correspondante du premier empilement 10.

Le procédé de fabrication comporte également une étape de détermination d'une température d'assemblage T_{c} à laquelle les deux empilements 10, 20 sont ultérieurement assemblés, cette température d'assemblage T_{c} étant telle que l'énergie surfacique de collage direct Eₛ dudit matériau métallique d'intérêt (or, cuivre ou titane) est supérieure ou égale à 0,5J/m². La température d'assemblage T_{c} est sensiblement comprise entre la température ambiante T_{amb} et la température d'épitaxie Tₑₚᵢ de la couche active 23. Par sensiblement comprise, on entend que les bornes sont comprises, à 10% près et de préférence à 5% près. La température d'assemblage T_{c} est la température à laquelle est exposée la structure formée des deux empilements 10, 20 alors mis en contact l'un de l'autre au niveau des faces de contact 17a, 25a des deux sous-couches de collage 17, 25. Cette exposition thermique à la température d'assemblage T_{c} peut être simultanée ou consécutive à la mise en contact des deux empilements 10, 20. Lorsqu'elle est consécutive à la mise en contact des deux empilements, il s'agit alors d'un recuit de consolidation à une température de recuit Tᵣ permettant d'augmenter l'énergie surfacique de collage dudit matériau métallique d'intérêt.

Autrement dit, l'étape ultérieure d'assemblage des deux empilements 10, 20 par collage direct peut être réalisée de l'une ou l'autre des manières suivantes :
- Mise en contact des deux empilements 10, 20 à la seule température d'assemblage T_{c}, celle-ci étant ici égale à la température ambiante T_{amb}, sans recuit de consolidation. La température ambiante T_{amb} est comprise, par exemple, entre 10°C et 30°C environ. Il s'agit alors d'un collage direct à température ambiante.
- Mise en contact des deux empilements 10, 20 à la seule température d'assemblage T_{c}, celle-ci étant ici supérieure à la température ambiante T_{amb}. Il s'agit alors d'un collage direct assisté en température, sans phase spécifique de recuit de consolidation.
- Mise en contact des deux empilements 10, 20 à une première température, par exemple à la température ambiante T_{amb}, suivi d'un recuit de consolidation à une température de recuit Tᵣ supérieure à la température ambiante T_{amb} et égale à la température d'assemblage T_{c}. Il s'agit alors d'un collage direct assisté en température, avec une phase spécifique de recuit de consolidation.

Ainsi, l'étape d'assemblage comporte une phase de mise en contact des empilements 10, 20, suivi éventuellement d'une phase de recuit de consolidation. La température d'assemblage T_{c} telle que l'énergie surfacique de collage direct Eₛ dudit matériau métallique d'intérêt est supérieure ou égale à 0,5J/m² correspond donc à la température ambiante T_{amb} ou à la température de recuit Tᵣ, laquelle est donc supérieure à la température ambiante T_{amb}, et inférieure ou sensiblement égale à la température d'épitaxie Tₑₚᵢ de la couche active 23. Elle est dite sensiblement égale à la température d'épitaxie Tₑₚᵢ dans le sens où elle est égale à la température Tₑₚᵢ à 10% près, et de préférence à 5% près. De préférence, la température de recuit est inférieure ou égale à 300°C. L'assemblage des empilements 10, 20 par collage direct peut donc être assisté en température, et peut en outre être assisté en pression. Dans ce cas, l'assemblage des empilements 10, 20 s'effectue en appliquant une force de pression aux empilements alors mis en contact.

Les inventeurs ont en effet constaté qu'un assemblage effectif des deux empilements 10, 20 l'un à l'autre était obtenu lorsque l'énergie surfacique de collage Eₛ du matériau métallique d'intérêt est supérieure ou égale à 0,5J/m², et de préférence, supérieure ou égale à 1J/m². Or, il apparaît que les matériaux métalliques que sont l'or, le cuivre et le titane présentent une énergie surfacique de collage direct qui peut être supérieure ou égale à 0,5J/m², et de préférence supérieure ou égale à 1J/m², lorsqu'ils sont soumis à une température d'assemblage T_{c} sensiblement comprise entre la température ambiante T_{amb} et la température d'épitaxie Tₑₚᵢ de la couche active 23. Il n'est donc pas nécessaire, pour obtenir les valeurs voulues d'énergie surfacique de collage, d'effectuer un recuit thermique à une température supérieure, à 10% près, à la température d'épitaxie Tₑₚᵢ de la couche active 23, ce qui permet d'éviter les risques de dégradation de la qualité cristalline de la couche active 23 par une démixtion éventuelle d'au moins une partie de l'étain contenu dans le germanium étain. En effet, l'or présente une énergie surfacique de collage direct Eₛ égale à 4J/m² environ à température ambiante T_{amb}, laquelle peut atteindre une valeur de 7J/m² environ lorsqu'il est soumis à une température de recuit Tᵣ de 300°C. Le cuivre présente une énergie surfacique de collage direct Eₛ de l'ordre de 1,5J/m² à température ambiante T_{amb}, laquelle peut augmenter jusqu'à 4J/m² voire davantage lorsqu'il est soumis à une température de recuit Tᵣ allant jusqu'à 300°C. Le titane présente une énergie surfacique de collage direct Eₛ égale à 0,1J/m² environ à température ambiante T_{amb}, laquelle atteint 1J/m² lorsqu'il est soumis à une température de recuit Tᵣ égale à 100°C, et jusqu'à 3J/m² environ lorsqu'il est soumis à une température de recuit Tᵣ de 300°C.

En référence à la figure 1C, on effectue l'étape d'assemblage par collage direct des deux empilements 10, 20 à la température d'assemblage T_{c} prédéterminée. De préférence, les faces de contact 17a, 25a présentent une rugosité inférieure ou égale à 5nm RMS dans le cadre d'un collage direct non assisté en pression, voire une rugosité inférieure ou égale à 30nm RMS dans le cadre d'un collage direct assisté en pression. Les empilements 10, 20 sont donc mis en contact l'un contre l'autre au niveau des faces de contact 17a, 25a des sous-couches de collage 17, 25, la température d'assemblage T_{c} étant égale à la température ambiante T_{amb} ou à ladite température de recuit Tᵣ, en fonction du matériau métallique d'intérêt choisi. Ainsi, les deux empilements 10,20 sont assemblés l'un à l'autre, sans apport de matériau collant spécifique (de type colle, glue, etc...) mais par le biais des forces attractives d'interaction atomique ou moléculaire entre le matériau métallique d'intérêt des deux sous-couches de collage 17, 25.

A titre d'exemple, la couche active 23 en Ge₁₋ₓSnₓ est réalisée par croissance épitaxie RPCVD avec une proportion atomique d'étain x_{Sn} égale à 13% environ de manière à obtenir une couche active 23 quasi-relaxée tout en ayant une structure de bandes directe. La température d'épitaxie Tₑₚᵢ est ici égale à 313°C environ. Dans le cas où le matériau métallique d'intérêt est de l'or ou du cuivre, l'assemblage des empilements 10, 20 par collage direct est effectué à une température d'assemblage T_{c} égale à la température ambiante T_{amb}, par exemple à 20°C environ, ou est avantageusement effectué à une température de recuit Tᵣ supérieure à la température ambiante T_{amb} et inférieure ou égale à la température d'épitaxie Tₑₚᵢ à 10% près, c'est-à-dire ici inférieure ou égale à 344°C, et de préférence inférieure ou égale à 329°C. Dans le cas où le matériau métallique d'intérêt est du titane, l'assemblage des empilements par collage direct est effectué à une température d'assemblage T_{c} égale à la température de recuit Tᵣ, laquelle est supérieure à la température ambiante T_{amb}, et inférieure ou égale à la température d'épitaxie Tₑₚᵢ à 10% près, c'est-à-dire ici inférieure ou égale à 344°C, et de préférence inférieure ou égale à 329°C.

Le procédé de fabrication comporte avantageusement une étape de suppression de la couche de nucléation 22 et du substrat de croissance 21, par exemple par meulage (*grinding,* en anglais), de manière à rendre libre une première face de la couche active 23 à base de GeSn, qui est alors la face d'émission 23b du dispositif optoélectronique 1, en particulier lorsque les matériaux du substrat de croissance 21 et de la couche de nucléation 22 présentent un coefficient d'absorption non nul du rayonnement lumineux infrarouge émis par la couche active 23. Par ailleurs, dans le cas où la couche active 23 est une couche épaisse, il est avantageux de supprimer également une partie de l'épaisseur de la couche active 23, en particulier la première zone 23.1 initialement en contact avec la couche de nucléation 22, dans la mesure celle-ci comporte des défauts structuraux associés à la relaxation plastique des contraintes mécaniques. Une couche mince de passivation 26, réalisée en un matériau diélectrique et transparent au rayonnement lumineux infrarouge, peut ensuite être déposée de manière à recouvrir la couche active 23.

Ainsi, le procédé de fabrication permet d'obtenir un dispositif optoélectronique 1 d'émission de lumière infrarouge comportant une source lumineuse d'excitation 11 et une couche active 23 à base de GeSn assemblées l'une à l'autre via un collage direct de deux empilements à basse température. Par le choix du matériau métallique d'intérêt de collage choisi parmi l'or, le cuivre et le titane, on obtient un assemblage des deux empilements 10, 20 à haute tenue mécanique, via un collage direct effectué à basse température (température ambiante ou température de recuit inférieure ou sensiblement égale à la température d'épitaxie de la couche active 23), ce qui permet d'éviter les risques de dégradation de la qualité cristalline de la couche active 23 à base de GeSn par une éventuelle démixtion partielle de l'étain contenu dans la couche.

De plus, le procédé de fabrication autorise la réalisation de la couche active 23 à base de GeSn d'une qualité cristalline élevée et présentant une structure de bandes d'énergie directe, que la couche active 23 soit quasi-relaxée et comporte une proportion atomique d'étain x_{Sn} élevée (par exemple de l'ordre de 12%), ou qu'elle subisse une contrainte mécanique en tension dans le plan de la couche et comporte une proportion atomique d'étain x_{Sn} plus faible (par exemple de l'ordre de 8%). Il peut également s'agir d'une couche active 23 pseudomorphique, c'est-à-dire ici en compression. Il est alors possible de réaliser une couche active 23 épaisse, par exemple à partir d'un pseudo-substrat formé d'un substrat de croissance 21 en silicium et d'une couche épaisse de nucléation en germanium, comme le décrit notamment la publication de Wirths 2015 mentionné précédemment, ou à partir d'une technique d'ingénierie des contraintes mécaniques en utilisant une couche intermédiaire à base de Ge_{1-y}Sn_{y} présentant une proportion atomique d'étain y_{Sn} supérieure à celle de la couche active 23, comme le décrit notamment la publication de Wirths et al. intitulée Tensely strained GeSn alloy as optical gain media, Appl. Phys. Lett. 103, 192110 (2013).

Le dispositif optoélectronique 1 comporte ainsi une couche intermédiaire métallique 30, formée par les deux sous-couches de collage 17, 25 assemblées l'une à l'autre. Il apparaît cependant que cette couche intermédiaire métallique 30, lorsqu'elle forme une couche plane d'épaisseur constante, présente un coefficient de transmission T relativement faible vis-à-vis du rayonnement lumineux d'excitation. Ainsi, à titre d'exemple, pour un rayonnement lumineux d'excitation de longueur d'onde λ₁ égale à 980nm, le coefficient de transmission T est de l'ordre de 20% pour une couche intermédiaire métallique 30 d'une épaisseur constante de 20nm environ en or ou en titane.

Aussi, le procédé de fabrication comporte avantageusement, lors de l'étape de réalisation du premier et/ou du deuxième empilements 10, 20, une phase de structuration en épaisseur de la première et/ou de la deuxième sous-couches de collage 17, 25, de sorte que la couche intermédiaire métallique 30 ainsi formée présente une structuration périodique en épaisseur dans le plan XY de la couche, c'est-à-dire qu'elle présente un réseau périodique 32 de motifs 34 mono- ou bidimensionnels. Les motifs 34 (traits pointillés) sont formés par une variation d'épaisseur locale de la couche intermédiaire métallique 30.

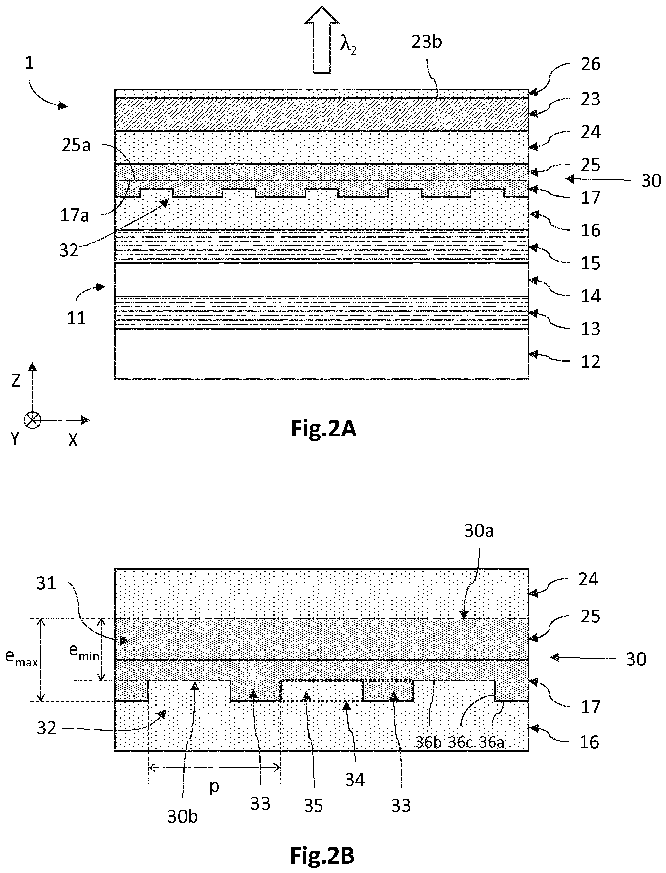

La figure 2A est une vue en coupe transversale, schématique et partielle, d'un dispositif optoélectronique 1 d'émission lumineuse infrarouge selon un autre mode de réalisation, qui se distingue essentiellement de celui illustré sur la fig.iD en ce que la couche intermédiaire métallique 30 comporte un réseau périodique 32. La figure 2B est une vue détaillée d'une partie de la couche intermédiaire métallique 30 interposée entre les deux couches de liaison 16, 24.

La structuration périodique en épaisseur de la couche intermédiaire métallique 30 se traduit par la répétition périodique, suivant une ou deux dimensions dans le plan XY de la couche, de motifs identiques 34 entraînant une variation d'épaisseur locale de la couche intermédiaire métallique 30. Chaque motif 34 est défini comme étant un plot 33 du matériau métallique d'intérêt, réalisé d'un seul tenant avec une partie continue 31 d'épaisseur constante eₘᵢₙ non nulle de la couche intermédiaire métallique 30, chaque plot 33 étant séparé des plots 33 adjacents par une échancrure 35 remplie par le matériau transparent de la couche de liaison 16. Les plots 33 forment donc des saillies vis-à-vis de la partie continue 31 d'épaisseur constante de la couche intermédiaire métallique 30. Le matériau métallique d'intérêt de la couche intermédiaire métallique 30 présente un indice de réfraction différent de celui du matériau transparent de la couche de liaison 16. D'une manière générale, un plot 33 peut présenter une forme quelconque (polygonale, circulaire, allongée etc...). Le réseau périodique 32 peut présenter une périodicité selon une ou deux dimensions : dans le cas d'une périodicité à une dimension, les plots 33 forment des lignes ou des barres distinctes et parallèles entre elles ; dans le cas d'une périodicité à deux dimensions, les plots 33 peuvent former des lignes ou barres fermées et concentriques. Les lignes ou barres peuvent s'étendre longitudinalement de manière continue ou non. Par ailleurs, la période peut être égale ou différente suivant les deux dimensions de périodicité du réseau 32.

La couche intermédiaire métallique 30 présente une face inférieure 30b au contact de la première couche de liaison 16, et une face supérieure 30a au contact de la deuxième couche de liaison 24. Aussi, la face inférieure 30b et/ou la face supérieure 30a sont structurées, c'est-à-dire qu'elle est formée de parties d'extrémité 36a au niveau desquelles l'épaisseur locale de la couche intermédiaire métallique 30 est maximale, et des parties de fond 36b au niveau desquelles l'épaisseur locale est minimale. Les parties de fond 36b et les parties d'extrémité 36a sont reliées entre elles par des parties latérales 36c. Dans cet exemple, la face inférieure 30b est structurée de manière à former le réseau périodique 32 alors que la face supérieure 30a est plane. En variante, ce peut être l'inverse, ou une structuration des deux faces inférieure 30b et supérieure 30a peut être réalisée. Notons que, dans les figures 2A et 2B, dans un souci de clarté, la structuration de la face inférieure 30b est représentée à angles droits, alors que, dans les faits, les angles sont plutôt localement arrondis.

On définit l'épaisseur minimale eₘᵢₙ et l'épaisseur maximale eₘₐₓ de la couche intermédiaire métallique 30 comme étant respectivement les distances locales minimale et maximale entre les faces inférieure 30b et supérieure 30a. Aussi, la couche intermédiaire métallique 30 comporte une partie continue 31 d'épaisseur minimale eₘᵢₙ non nulle, et le réseau périodique 32 est défini par, d'une part, la période p d'agencement périodique des plots 33 dans le plan XY, et d'une part, un taux de remplissage φ égal au rapport entre le volume du matériau métallique d'intérêt dans un motif 34 sur le volume total du motif considéré. La période p est de préférence sub-longueur d'onde, c'est-à-dire qu'elle est de préférence inférieure à la longueur d'onde λ₁ du rayonnement lumineux d'excitation. De préférence, la période p est comprise entre 0,1µm et 1µm lorsque la longueur d'onde λ₁ est égale à 980nm environ ou à 1300nm environ. Par ailleurs, la hauteur des plots 33, c'est-à-dire la distance suivant l'axe Z entre un plan passant par les parties de fond 36b et un plan passant par les parties d'extrémité 36a des plots 33, est de préférence comprise entre 1nm et 10nm.

Dans cet exemple, le réseau périodique 32 de la couche intermédiaire métallique 30 est obtenu de la manière suivante. La première couche de liaison 16 est structurée en épaisseur de manière à ce que sa face supérieure 16a présente des échancrures réparties périodiquement et dont la profondeur est sensiblement égale à la hauteur souhaitée des plots 33 du réseau périodique 32. Ici, les échancrures présentent une profondeur égale à 5nm environ. Elles peuvent être obtenues par une technique de lithographie conventionnelle ou de type nano-impression, ou toute autre technique équivalente suivie de gravure et retrait de la résine. Sur la face supérieure 16a ainsi structurée, la première sous-couche de collage 17 est déposée de manière à recouvrir la face supérieure 16a et à remplir les échancrures. Les portions de métal de collage situées dans les échancrures forment ainsi les plots 33 du réseau périodique 32. Une planarisation mécano-chimique (CMP) peut être effectuée de manière à rendre plane la face de contact 17a de la sous-couche de collage 17. Ainsi, la sous-couche de collage 17 comporte une partie continue d'épaisseur constante, par exemple d'une épaisseur de 10nm environ, vis-à-vis de laquelle sont en saillie les plots 33 du réseau périodique 32 suivant la direction -Z. Dans cet exemple, la deuxième sous-couche de collage 25 n'est pas structurée en épaisseur : elle présente ainsi une épaisseur constante, par exemple égale à 10nm environ. Aussi, après assemblage des deux empilements 10, 20 par collage direct au niveau des faces de contact 17a, 25a des sous-couches de collage 17, 25, on obtient une couche intermédiaire métallique 30 formée d'une partie continue 31 d'épaisseur constante, ici égale à 20nm environ, vis-à-vis de laquelle sont en saillie les plots 33 du réseau périodique 32 à l'interface avec la première couche de liaison 16.

Il apparaît, de manière surprenante, que pour certaines valeurs des paramètres géométriques p et φ du réseau périodique 32, le coefficient de transmission T de la couche intermédiaire métallique 30 comportant ce réseau périodique 32 à dimensions optimisées présente une valeur sensiblement plus importante que pour une même couche intermédiaire métallique 30 ne comportant pas un tel réseau périodique 32, c'est-à-dire pour une couche intermédiaire métallique 30 plane et d'une épaisseur constante égale à la épaisseur minimale eₘᵢₙ de la couche intermédiaire métallique 30 ayant le réseau périodique 32.

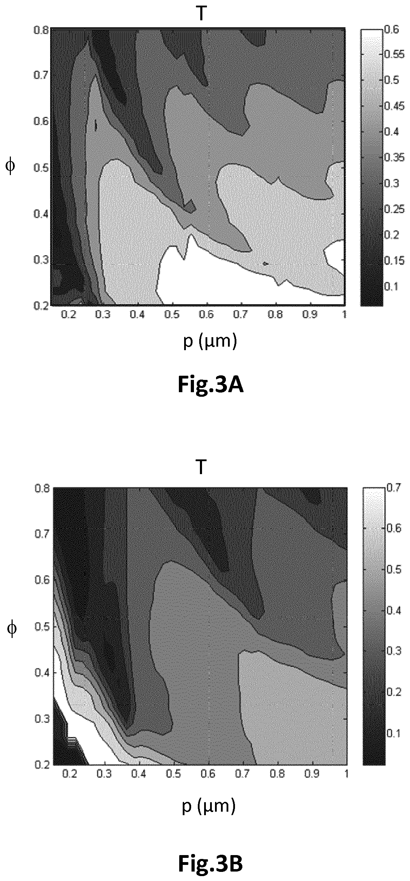

A ce titre, les figures 3A et 3B illustrent deux exemples d'évolution du coefficient de transmission T de la couche intermédiaire métallique 30 interposée entre deux couches de liaison 16, 24, pour différentes valeurs de la période p et du taux de remplissage φ. Dans ces exemples, la couche intermédiaire métallique 30 est disposée entre deux couches de liaison 16, 24 réalisées en silicium amorphe intrinsèque.

Dans ces deux exemples, la couche intermédiaire métallique 30 est réalisée en or, et présente une épaisseur minimale eₘᵢₙ égale à 20nm environ. Elle est ainsi formée d'une partie continue 31 d'épaisseur constante eₘᵢₙ contenant la deuxième sous-couche de collage 25 d'épaisseur constante égale à 10nm et d'une partie d'épaisseur constante égale à 10nm de la première sous-couche de collage 17. Elle est formée également d'un réseau périodique 32 situé à l'interface avec la première couche de liaison 16. Le réseau périodique 32 comporte des plots 33 d'une hauteur de 5nm environ, disposés en saillie de la partie continue 31. Aussi, la couche intermédiaire métallique 30 présente une épaisseur minimale eₘᵢₙ égale à 20nm et une épaisseur maximale eₘₐₓ égale à 25nm. Le réseau périodique 32 présente ici une périodicité à une dimension et les plots 33 forment des lignes parallèles les unes aux autres.

Dans l'exemple de la fig.3A, le rayonnement lumineux d'excitation présente une longueur d'onde centrale λ₁ égale à 980nm. Il apparaît alors que le coefficient de transmission T présente des valeurs maximales lorsque la période p est comprise entre 0,4µm et 1,0µm environ, et le taux de remplissage φ est compris entre 0,2 et 0,4 environ. Ainsi, le coefficient de transmission présente une valeur optimale de 69% environ lorsque la période p est égale 0,85µm à 10% près, et le taux de remplissage égal à 0,20 à 10% près.

Dans l'exemple de la fig.3B, le rayonnement lumineux d'excitation présente une longueur d'onde centrale λ₁ égale à 1300nm. Il apparaît alors que le coefficient de transmission T présente des valeurs maximales lorsque la période p passe de 0,1µm à 0,3µm environ à mesure que le taux de remplissage φ passe de 0,2 à 0,4 environ. Ainsi, le coefficient de transmission présente une valeur optimale de 75% environ lorsque la période p est égale 0,25µm à 10% près, et le taux de remplissage égal à 0,3 à 10% près.

Il apparaît ainsi que ces valeurs optimales du coefficient de transmission T sont bien supérieures à la valeur de 20% correspondant à une couche intermédiaire métallique 30 réalisée en or présentant une épaisseur constante égale à 20nm environ, c'est-à-dire sans réseau périodique 32. Aussi, par la structuration de la couche intermédiaire métallique 30 de sorte qu'elle présente un réseau périodique 32 et par l'étape de détermination des paramètres géométriques correspondants (période p, dimensions des plots 33 : ici taux de remplissage φ), il est possible d'améliorer grandement le coefficient de transmission du rayonnement lumineux d'excitation au travers de la couche intermédiaire métallique 30, et ainsi d'améliorer la performance optique du dispositif optoélectronique 1. Le taux de remplissage est l'un des paramètres géométriques possibles permettant de définir le réseau périodique 32. D'autres paramètres peuvent être utilisés, comme le rapport de forme des plots 33 et celui des échancrures adjacentes, entre autres.

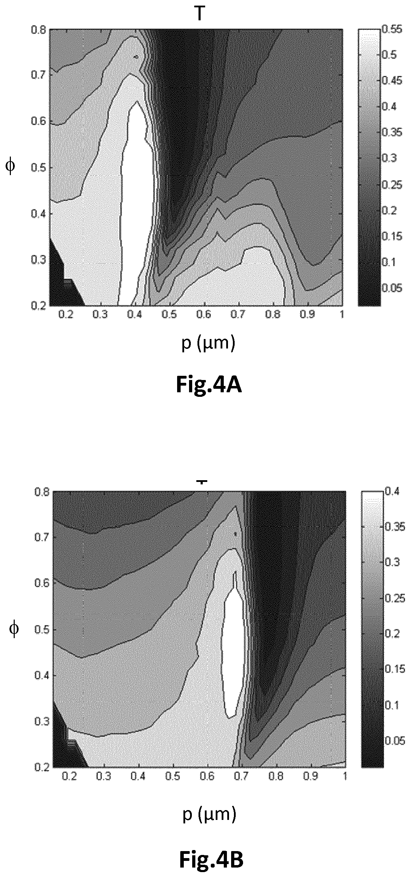

Les figures 4A et 4B illustrent deux exemples d'évolution du coefficient de transmission T de la couche intermédiaire métallique 30 interposée entre deux couches de liaison 16, 24, pour différentes valeurs de la période p et du taux de remplissage φ. Dans ces exemples, la couche intermédiaire métallique 30 est disposée entre deux couches de liaison 16, 24 réalisées en un oxyde de silicium, ici du SiO₂.

Dans l'exemple de la fig.4A, le rayonnement lumineux d'excitation présente une longueur d'onde centrale λ₁ égale à 980nm. Il apparaît alors que le coefficient de transmission T présente des valeurs maximales lorsque la période p est égale à 0,4µm à 10% près, et que le taux de remplissage φ est compris entre 0,2 et 0,7 environ. Ainsi, le coefficient de transmission présente une valeur optimale de 59% environ lorsque la période p est égale 0,4µm à 5% près, et le taux de remplissage égal à 0,45 à 10% près.

Dans l'exemple de la fig.4B, le rayonnement lumineux d'excitation présente une longueur d'onde centrale λ₁ égale à 1300nm. Il apparaît alors que le coefficient de transmission T présente des valeurs maximales lorsque la période p est égale à 0,65µm à 5% près, et que le taux de remplissage φ est compris entre 0,25 et 0,65 environ. Ainsi, le coefficient de transmission présente une valeur optimale de 43% environ lorsque la période p est égale 0,45µm à 5% près, et le taux de remplissage égal à 0,45 à 10% près.

Il apparaît que l'évolution du coefficient de transmission du rayonnement lumineux d'excitation au travers de la couche intermédiaire métallique 30 dépend également des propriétés optiques du matériau des couches de liaison 16, 24, et notamment de son indice de réfraction. En effet, le coefficient de transmission T, à dimensionnement inchangé de la couche intermédiaire métallique 30 et de son réseau périodique 32, présente une évolution différente selon que le matériau des couches de liaison 16, 24 est du silicium amorphe (fig.3A et 3B) ou est un oxyde de silicium (fig.4A et 4B). Quoi qu'il en soit, la structuration de la couche intermédiaire métallique 30 de manière à former un réseau périodique 32 à paramètres géométriques prédéterminés permet d'améliorer grandement le coefficient de transmission T du rayonnement lumineux d'excitation au travers de la couche intermédiaire métallique 30, et ainsi d'améliorer la performance optique du dispositif optoélectronique 1.

Le dispositif optoélectronique 1 peut ainsi comporter une source VCSEL comme source lumineuse d'excitation 11. Dans ce cas, la couche intermédiaire métallique 30 recouvre le miroir supérieur 15 de la source VCSEL 11 et est séparée de celui-ci par la première couche de liaison 16. Cependant, il apparaît que la présence de la couche intermédiaire métallique 30 peut induire une perturbation des propriétés optiques du miroir supérieur 15 de la source VCSEL 11 et donc de la cavité résonante de celle-ci.

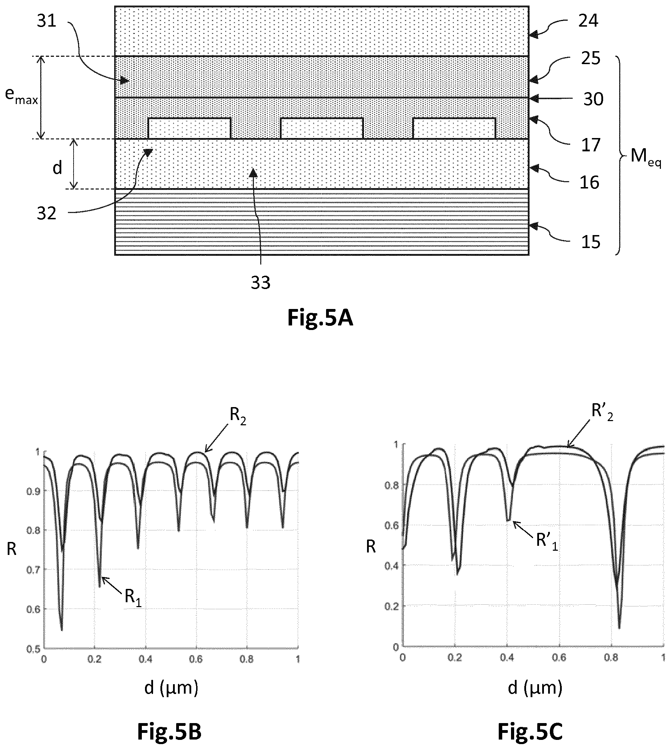

La figure 5A est une vue en coupe transversale et schématique d'une partie d'un dispositif optoélectronique 1 selon un mode de réalisation. Ici, la couche intermédiaire métallique 30 est disposée à une distance d du miroir supérieur 15 de la source VCSEL 11. La distance d séparant le miroir supérieur 15 de la couche intermédiaire métallique 30 est définie comme étant la distance suivant l'axe Z entre la face supérieure 15a du miroir supérieur 15 de la source VCSEL 11, et du plan passant par les parties d'extrémité 36a, le cas échéant, de la face inférieure 30b de la couche intermédiaire métallique 30. On note par ailleurs M_{eq} le miroir équivalent formé du miroir supérieur 15 de la source VCSEL et de la couche intermédiaire métallique 30 (celle-ci comportant un coefficient de réflexion non nul vis-à-vis du rayonnement lumineux d'excitation). Le miroir M_{eq} participe à définir la cavité optique de la source VCSEL 11 : aussi, on souhaite qu'il présente un coefficient de réflexion R élevé vis-à-vis du rayonnement lumineux d'excitation. Cependant, il apparaît que le rayonnement lumineux d'excitation présente des interférences destructives dans la cavité Fabry-Pérot formée par le miroir supérieur 15 de la source VCSEL et la couche intermédiaire métallique 30.

A ce titre, les figures 5B et 5C illustrent des exemples d'évolution du coefficient de réflexion R du miroir équivalent M_{eq} vis-à-vis du rayonnement lumineux d'excitation de longueur d'onde centrale λ₁ en fonction de la distance d séparant le miroir supérieur 15 de la source VCSEL 11 de la couche intermédiaire métallique 30. Les courbes R₁ et R'₁ correspondent à une couche intermédiaire métallique 30 sans réseau périodique 32, et les courbes R₂ et R'₂ correspond à une couche intermédiaire métallique 30 avec réseau périodique 32 optimisé.

Il apparaît que le coefficient de réflexion R dépend effectivement de la distance d : il présente ainsi une chute périodique de sa valeur à mesure que varie la distance d. Cette chute périodique du coefficient de réflexion R peut conduire à une dégradation des propriétés optiques du miroir équivalent M_{eq}, et donc du miroir supérieur 15 de la source VCSEL 11, dans le cas où la distance d n'est pas correctement choisie. Aussi, les propriétés de la cavité résonante de la source VCSEL 11 sont modifiées par un mauvais positionnement de la couche intermédiaire métallique 30 vis-à-vis du miroir supérieur 15 sous-jacent, et les performances du dispositif optoélectronique 1 peuvent être dégradées. Par ailleurs, cette chute périodique du coefficient de réflexion R s'observe dès lors qu'une couche intermédiaire métallique 30 en un matériau métallique d'intérêt choisi parmi l'or, le cuivre et le titane est présente, qu'elle comporte ou non le réseau périodique 32.

Ainsi, l'exemple de la fig.5B correspond à un miroir supérieur 15 de la source VCSEL 11 formé d'une alternance d'une couche quart d'onde de GaAlAs de 75nm d'épaisseur et d'une couche quart d'onde de AlAs de 77nm d'épaisseur, pour obtenir la transmission d'un rayonnement lumineux d'excitation dont la longueur d'onde centrale est égale à 980nm environ. Les couches de liaison sont réalisées en silicium amorphe intrinsèque, et la couche intermédiaire métallique 30 est réalisée en or et présente une épaisseur minimale eₘᵢₙ égale à 20nm environ. Deux courbes R₁ et R₂ sont représentées et correspondent respectivement à une couche intermédiaire métallique 30 sans et avec un réseau périodique 32 optimisé. Le réseau périodique 32 présente des paramètres géométriques (période p et taux de remplissage φ) déterminés pour maximiser le coefficient de transmission T du rayonnement lumineux d'excitation incident à la longueur d'onde λ₁. Ici, la période p est égale à 700nm environ et le taux de remplissage φ est égal à 0,25 environ. Dans le cas où la couche intermédiaire métallique 30 ne comporte pas de réseau périodique 32 (courbe R₁), il apparaît que le coefficient de réflexion R présente des valeurs minimales variant entre 55% et 80% en fonction de la distance d, et une valeur maximale de l'ordre de 95%. Dans le cas où la couche intermédiaire métallique 30 comporte le réseau périodique 32 optimisé (courbe R₂), le coefficient de réflexion R présente des valeurs minimales variant entre 75% et 90% en fonction de la distance d, et une valeur maximale de l'ordre de 99%. Il en ressort que lorsque la couche intermédiaire métallique 30 comporte un réseau périodique 32 optimisé comme décrit précédemment, la dégradation des propriétés optiques du miroir équivalent M_{eq}, et donc celles de la cavité optique de la source VCSEL, est réduite. De plus, il est possible de déterminer une distance d permettant de limiter toute dégradation des propriétés optiques du miroir équivalent M_{eq}, et donc de celles de la cavité optique de la source VCSEL 11. Dans cet exemple, la distance d est de préférence égale à 500nm environ vérifiant la condition de phase (différence de phase égale à zéro modulo 2*π*) entre l'onde réfléchie sur le miroir supérieur 15 de la source VCSEL avec l'onde réfléchie par la couche intermédiaire métallique 30.

Par ailleurs, l'exemple de la fig.5C correspond à un miroir supérieur 15 de la source VCSEL 11 formé d'une alternance d'une couche quart d'onde de GaAs de 95nm d'épaisseur et d'une couche quart d'onde de AlAs de 112nm d'épaisseur, pour obtenir la transmission d'un rayonnement lumineux d'excitation dont la longueur d'onde centrale est égale à 1300nm environ. Les couches de liaison 16, 24 sont réalisées en oxyde de silicium, ici du SiO₂, et la couche intermédiaire métallique 30 est réalisée en or et présente une épaisseur minimale eₘᵢₙ égale à 20nm environ. Deux courbes R'₁ et R'₂ sont représentées et correspondent respectivement à une couche intermédiaire métallique 30 sans ou avec un réseau périodique 32 optimisé. Le réseau périodique 32 présente une période p égale à 650nm environ et le taux de remplissage φ est égal à 0,5 environ. Dans le cas où la couche intermédiaire métallique 30 ne comporte pas de réseau périodique 32 (courbe R'₁), il apparaît que le coefficient de réflexion R présente des valeurs minimales variant entre 15% et 60% en fonction de la distance d, et une valeur maximale de l'ordre de 90%. Dans le cas où la couche intermédiaire métallique 30 comporte le réseau périodique 32 optimisé (courbe R'2), le coefficient de réflexion R présente des valeurs minimales variant entre 30% et 80% en fonction de la distance d, et une valeur maximale de l'ordre de 99%. Il en ressort que, ici également, lorsque la couche intermédiaire métallique 30 comporte un réseau périodique 32 optimisé, la dégradation des propriétés optiques du miroir équivalent M_{eq}, et donc celles de la cavité optique de la source VCSEL, est réduite. De plus, il est possible de déterminer une distance d permettant de limiter toute dégradation des propriétés optiques du miroir équivalent M_{eq}, et donc de celles de la cavité optique de la source VCSEL. Dans cet exemple, la distance d est de préférence égale à 600nm environ vérifiant la condition de phase (différence de phase égale à zéro modulo 2*π*) entre l'onde réfléchie sur le miroir supérieur 15 de la source VCSEL avec l'onde réfléchie par la couche intermédiaire métallique 30.

Aussi, le procédé de fabrication du dispositif optoélectronique 1 comporte avantageusement une étape de détermination de la distance d séparant la couche intermédiaire métallique 30 vis-à-vis du miroir supérieur 15 de la source VCSEL 11. Pour cela, compte tenu des propriétés optiques du miroir supérieur 15 de la source VCSEL 11 (longueur d'onde centrale λ₁), et de celles de la couche intermédiaire métallique 30 (avec ou sans réseau périodique 32), on calcule l'évolution du coefficient de réflexion R d'un tel miroir équivalent M_{eq} en fonction de la distance d. Le calcul peut être effectué par simulation numérique, par exemple au moyen du logiciel RSoft avec les méthodes RCWA ou FDTD.

Par ailleurs, il apparaît que la couche intermédiaire métallique 30 comportant le réseau périodique 32 réfléchit efficacement le rayonnement lumineux émis par la couche active 23, dans la mesure où la longueur d'onde λ₂ est supérieure à la longueur d'onde λ₁ du rayonnement lumineux émis par la source VCSEL, améliorant alors les propriétés diffractantes et réfléchissantes du réseau périodique 32. A ce titre, l'interaction optique entre la couche active 23 à base de GeSn et la couche intermédiaire métallique 30 peut être optimisée. Pour cela, on choisit notamment la distance entre ces deux couches 23, 30 de sorte que la condition de phase (différence de phase égale à zéro modulo 2*π*) soit vérifiée entre l'onde optique de longueur d'onde λ₂ émise par la couche active 23 suivant la direction +Z et l'onde optique de longueur d'onde λ₂ réfléchie/diffractée par le réseau périodique 32 suivant la direction -Z.

Des modes de réalisation particuliers viennent d'être décrits. Différentes variantes et modifications apparaîtront à l'homme du métier. Ainsi, le dispositif optoélectronique 1 peut comporter une matrice de pixels émissifs, les pixels étant formés de portions distinctes d'une couche active 23 à base de GeSn disposées sur des sources lumineuses d'excitation, distinctes et disposées de manière coplanaire.

Par ailleurs, comme mentionné précédemment, la source lumineuse d'excitation 11 peut être formée d'une diode électroluminescente ou être une diode laser de type VCSEL. Le rayonnement lumineux émis par la couche active 23 en réponse à l'absorption du rayonnement lumineux d'excitation peut être cohérent ou non. Dans le cas d'un rayonnement lumineux cohérent, la couche active 23 peut comporter une structuration périodique de type cristaux photoniques, de manière à former une cavité optique résonante au sein de la couche active 23 et orientée dans le plan de la couche 23, permettant la génération d'un rayonnement lumineux infrarouge cohérent. Une structuration similaire est notamment décrite dans la publication de Thai et al. intitulée 2D hexagonal photonic crystal GeSn laser with 16% Sn content, Appl. Phys. Lett. 113, 051104 (2018).

## Revendications

1. Procédé de fabrication d'un dispositif optoélectronique (1) d'émission d'un rayonnement lumineux infrarouge, comportant les étapes suivantes :
i) réalisation d'un premier empilement (10) comportant :
• une source lumineuse (11) d'un rayonnement lumineux d'excitation,
• une première sous-couche de collage (17) réalisée en un matériau métallique d'intérêt choisi parmi l'or, le titane et le cuivre, présentant une première face de contact (17a),
• entre lesquelles est disposée une première couche de liaison (16) réalisée en un matériau transparent au rayonnement lumineux d'excitation ;
ii) réalisation d'un deuxième empilement (20) comportant :
• une couche active (23) à base de GeSn adaptée à absorber le rayonnement lumineux d'excitation et à émettre en réponse le rayonnement lumineux infrarouge, présentant une proportion atomique d'étain (x_{Sn}) telle qu'elle présente une structure de bandes d'énergie directe, et étant obtenue par croissance épitaxiale à une température d'épitaxie (Tₑₚᵢ),
• une deuxième sous-couche de collage (25) réalisée en ledit matériau métallique d'intérêt, présentant une deuxième face de contact (25a),
• entre lesquelles est disposée une deuxième couche de liaison (24) réalisée en un matériau transparent au rayonnement lumineux d'excitation ;
iii) détermination d'une température d'assemblage (T_{c}) comprise entre une température ambiante (T_{amb}) et ladite température d'épitaxie (Tₑₚᵢ), à 10% près, telle qu'une énergie surfacique de collage direct dudit matériau métallique d'intérêt est supérieure ou égale à 0,5J/m² ;
iv) assemblage par collage direct, à ladite température d'assemblage (T_{c}), desdits empilements (10, 20) au niveau desdites faces de contact (17a, 25a).

2. Procédé de fabrication selon la revendication 1, comportant :
- une phase de structuration en épaisseur de la première sous-couche de collage (17) et/ou de la deuxième sous-couche de collage (25), de sorte que la couche intermédiaire métallique (30) formée par lesdites sous-couches de collage (17, 25) assemblées l'une à l'autre comporte au moins un réseau périodique (32), la couche intermédiaire métallique (30) présentant une épaisseur minimale (eₘᵢₙ) non nulle ;
- une phase de détermination, préalable à la phase de structuration, de paramètres géométriques (p, φ) du réseau périodique (32), de sorte que la couche intermédiaire métallique (30) présente un coefficient de transmission (T) du rayonnement lumineux d'excitation d'une valeur supérieure à une valeur prédéterminée correspondant à une couche intermédiaire métallique (30) équivalente sans réseau périodique, plane et d'une épaisseur constante égale à ladite épaisseur minimale (eₘᵢₙ).

3. Procédé de fabrication selon la revendication 2, dans lequel le réseau périodique (32) est situé à l'interface avec la première et/ou la deuxième couches de liaison (16, 24), lesdites faces de contact (17a, 25a) étant planes.

4. Procédé de fabrication selon la revendication 2 ou 3, dans lequel la couche intermédiaire métallique (30) comporte au moins une partie continue (31) d'une première épaisseur constante égale à l'épaisseur minimale (eₘᵢₙ) et des plots (33) agencés en saillie vis-à-vis de la partie continue (31) et formant le réseau périodique (32).

5. Procédé de fabrication selon l'une quelconque des revendications 1 à 4, la source lumineuse d'excitation (11) étant une diode électroluminescente ou une source laser à cavité verticale émettant par la surface.

6. Procédé de fabrication selon l'une quelconque des revendications 1 à 5, dans lequel la source lumineuse d'excitation (11) est une source laser à cavité verticale émettant par la surface comportant un réflecteur inférieur (13) et un réflecteur supérieur (15) entre lesquels est disposé un milieu à gain (14), le réflecteur supérieur (15) étant au contact et recouvert par la première couche de liaison (16), le procédé comportant :
- une phase de détermination, préalable à la phase de réalisation du premier empilement (10), d'une épaisseur (d) de la première couche de liaison (16), de sorte qu'un réflecteur équivalent (M_{eq}) formé par le réflecteur supérieur (15) et par la couche intermédiaire métallique (30), séparés l'un de l'autre par la première couche de liaison (16), présente un coefficient de réflexion (R) du rayonnement lumineux d'excitation d'une valeur supérieure à une valeur prédéterminée.

7. Procédé de fabrication selon l'une quelconque des revendications 1 à 6, dans lequel la température d'assemblage (T_{c}) est inférieure ou égale à la température d'épitaxie (Tₑₚᵢ) à 10% près.

8. Procédé de fabrication selon l'une quelconque des revendications 1 à 7, dans lequel le matériau transparent des couches de liaison (16, 24) est un matériau diélectrique.

9. Procédé de fabrication selon l'une quelconque des revendications 1 à 8, dans lequel le matériau transparent des couches de liaison (16, 24) est à base de silicium.

10. Procédé de fabrication selon l'une quelconque des revendications 1 à 9, dans lequel les deux sous-couches de collage (17, 25) assemblées l'une à l'autre forment une couche intermédiaire métallique (30) présentant une épaisseur moyenne comprise entre 5nm et 40nm.

11. Procédé de fabrication selon l'une quelconque des revendications 1 à 10, comportant une étape de structuration de la couche active (23) à base de GeSn de manière à former une cavité résonante orientée dans le plan de la couche active (23).

12. Dispositif optoélectronique (1) d'émission d'un rayonnement lumineux infrarouge, comportant un empilement de :
- une source lumineuse (11) d'un rayonnement lumineux d'excitation ;
- une première sous-couche de collage (17) réalisée en un matériau métallique d'intérêt choisi parmi l'or, le titane et le cuivre, présentant une première face de contact (17a) ;
- une première couche de liaison (16) réalisée en un matériau transparent au rayonnement lumineux d'excitation, disposée entre la source lumineuse (11) et la première sous-couche de collage (17) ;
- une deuxième sous-couche de collage (25) réalisée en ledit matériau métallique d'intérêt, présentant une deuxième face de contact (25a) assemblée et au contact de la première face de contact (17a) ;
- une couche active (23) à base de GeSn, présentant une proportion atomique d'étain (x_{Sn}) telle qu'elle présente une structure de bandes d'énergie directe, et adaptée à absorber le rayonnement lumineux d'excitation et à émettre en réponse le rayonnement lumineux infrarouge ;
- une deuxième couche de liaison (24) réalisée en un matériau transparent au rayonnement lumineux d'excitation, disposée entre la couche active (23) et la deuxième sous-couche de collage (25).

13. Dispositif optoélectronique (1) selon la revendication 12, dans lequel la première sous-couche de collage (17) et/ou la deuxième sous-couche de collage (25) présentent une structuration en épaisseur de sorte que la couche intermédiaire métallique (30), formée par lesdites sous-couches de collage (17, 25) assemblées l'une à l'autre, comporte au moins un réseau périodique (32) et présente une épaisseur minimale (eₘᵢₙ) non nulle, le réseau périodique (32) étant défini par des paramètres géométriques (p, φ) tels que la couche intermédiaire métallique (30) présente un coefficient de transmission (T) du rayonnement lumineux d'excitation d'une valeur supérieure à une valeur correspondant à une couche intermédiaire métallique (30) équivalente sans réseau périodique, plane et d'une épaisseur constante égale à ladite épaisseur minimale (eₘᵢₙ).

## Patentansprüche

1. Verfahren zur Herstellung einer optoelektronischen Vorrichtung (1) zur Emission einer Infrarotlichtstrahlung, das die folgenden Schritte aufweist:
i) Herstellen eines ersten Stapels (10), der aufweist:
• eine Lichtquelle (11) einer Anregungslichtstrahlung,
• eine erste Klebeunterschicht (17), hergestellt aus einem interessierenden metallischen Material, das aus Gold, Titan und Kupfer ausgewählt wird, die eine erste Kontaktseite (17a) aufweist,
• zwischen denen eine erste Verbindungsschicht (16) angeordnet wird, die aus einem für die Anregungslichtstrahlung transparenten Material hergestellt ist;
ii) Herstellen eines zweiten Stapels (20), der aufweist:
• eine aktive Schicht (23) auf der Basis von GeSn, die geeignet ist, die Anregungslichtstrahlung zu absorbieren und als Reaktion die Infrarotlichtstrahlung zu emittieren, die einen derartigen Atomanteil von Zinn (x_{Sn}) aufweist, dass sie eine Struktur von direkten Energiebändern aufweist, und die durch epitaxiales Wachstum bei einer Epitaxietemperatur (Tₑₚᵢ) erhalten wird,
• eine zweite Klebeunterschicht (25), hergestellt aus dem interessierenden metallischen Material, die eine zweite Kontaktseite (25a) aufweist,
• zwischen denen eine zweite Verbindungsschicht (24) angeordnet wird, die aus einem für die Anregungslichtstrahlung transparenten Material hergestellt ist;
iii) Bestimmen einer Zusammenfügungstemperatur (T_{c}) zwischen einer Umgebungstemperatur (T_{amb}) und der Epitaxietemperatur (Tₑₚᵢ), bis auf 10%, derart, dass eine Oberflächenenergie direkten Klebens des interessierenden metallischen Materials größer als oder gleich 0,5J/m² ist;
iv) Zusammenfügen durch direktes Kleben, bei der Zusammenfügungstemperatur (T_{c}), der Stapel (10, 20) im Bereich der Kontaktseiten (17a, 25a).

2. Herstellungsverfahren nach Anspruch 1, das aufweist:
- eine Phase der Dickenstrukturierung der ersten Klebeunterschicht (17) und/oder der zweiten Klebeunterschicht (25), derart, dass die von den zusammengefügten Klebeunterschichten (17, 25) gebildete metallische Zwischenschicht (30) mindestens ein periodisches Gitter (32) aufweist, wobei die metallische Zwischenschicht (30) eine Mindestdicke (eₘᵢₙ) ungleich Null aufweist;
- eine Bestimmungsphase, vor der Strukturierungsphase, von geometrischen Parametern (p, φ) des periodischen Gitters (32), damit die metallische Zwischenschicht (30) einen Übertragungskoeffizienten (T) der Anregungslichtstrahlung eines Werts höher als ein vorbestimmter Wert aufweist, der einer äquivalenten metallischen Zwischenschicht (30) ohne periodisches Gitter, eben und von einer konstanten Dicke gleich der Mindestdicke (eₘᵢₙ) entspricht.

3. Herstellungsverfahren nach Anspruch 2, wobei das periodische Gitter (32) sich an der Schnittstelle mit der ersten und/oder der zweiten Verbindungsschicht (16, 24) befindet, wobei die Kontaktseiten (17a, 25a) eben sind.

4. Herstellungsverfahren nach Anspruch 2 oder 3, wobei die metallische Zwischenschicht (30) mindestens einen durchgehenden Teil (31) einer ersten konstanten Dicke gleich der Mindestdicke (eₘᵢₙ) und vorstehend angeordnete Blöcke (33) gegenüber dem durchgehenden Teil (31) angeordnet und das periodische Gitter (32) bildend aufweist.

5. Herstellungsverfahren nach einem der Ansprüche 1 bis 4, wobei die Anregungslichtquelle (11) eine Elektrolumineszenzdiode oder eine oberflächenemittierende Laserquelle mit Vertikalresonator ist.

6. Herstellungsverfahren nach einem der Ansprüche 1 bis 5, wobei die Anregungslichtquelle (11) eine oberflächenemittierende Laserquelle mit Vertikalresonator ist, die einen unteren Reflektor (13) und einen oberen Reflektor (15) aufweist, zwischen denen ein Verstärkungsmedium (14) angeordnet ist, wobei der obere Reflektor (15) mit der ersten Verbindungsschicht (16) in Kontakt ist und von ihr bedeckt wird, wobei das Verfahren aufweist:
- eine Bestimmungsphase, vor der Herstellungsphase des ersten Stapels (10), einer Dicke (d) der ersten Verbindungsschicht (16), so dass ein vom oberen Reflektor (15) und von der metallischen Zwischenschicht (30), die durch die erste Verbindungsschicht (16) voneinander getrennt sind, geformter äquivalenter Reflektor (M_{eq}) einen Reflexionskoeffizienten (R) der Anregungslichtstrahlung eines höheren Werts als ein vorbestimmter Wert aufweist.

7. Herstellungsverfahren nach einem der Ansprüche 1 bis 6, wobei die Zusammenfügungstemperatur (T_{c}) bis auf 10% niedriger als die oder gleich der Epitaxietemperatur (Tₑₚᵢ) ist.

8. Herstellungsverfahren nach einem der Ansprüche 1 bis 7, wobei das transparente Material der Verbindungsschichten (16, 24) ein dielektrisches Material ist.

9. Herstellungsverfahren nach einem der Ansprüche 1 bis 8, wobei das transparente Material der Verbindungsschichten (16, 24) auf der Basis von Silicium ist.

10. Herstellungsverfahren nach einem der Ansprüche 1 bis 9, wobei die zwei zusammengefügten Klebeunterschichten (17, 25) eine metallische Zwischenschicht (30) bilden, die eine mittlere Dicke zwischen 5nm und 40nm aufweist.

11. Herstellungsverfahren nach einem der Ansprüche 1 bis 10, das einen Schritt der Strukturierung der aktiven Schicht (23) auf der Basis von GeSn aufweist, um einen in der Ebene der aktiven Schicht (23) ausgerichteten Resonanzhohlraum zu bilden.

12. Optoelektronische Vorrichtung (1) zur Emission einer Infrarotlichtstrahlung, die einen Stapel aufweist von:
- einer Lichtquelle (11) einer Anregungslichtstrahlung;
- einer ersten Klebeunterschicht (17), hergestellt aus einem interessierenden metallischen Material ausgewählt unter Gold, Titan und Kupfer, die eine erste Kontaktseite (17a) aufweist;
- einer ersten Verbindungsschicht (16), hergestellt aus einem für die Anregungslichtstrahlung transparenten Material, angeordnet zwischen der Lichtquelle (11) und der ersten Klebeunterschicht (17);
- einer zweiten Klebeunterschicht (25), hergestellt aus dem interessierenden metallischen Material, die eine zweite Kontaktseite (25a) aufweist, die mit der ersten Kontaktseite (17a) zusammengefügt und mit ihr in Kontakt ist;
- einer aktiven Schicht (23) auf der Basis von GeSn, die einen Atomanteil von Zinn (x_{Sn}) derart aufweist, dass sie eine Struktur von direkten Energiebändern aufweist, und geeignet ist, die Anregungslichtstrahlung zu absorbieren und als Reaktion die Infrarotlichtstrahlung zu emittieren;
- einer zweiten Verbindungsschicht (24), hergestellt aus einem für die Anregungslichtstrahlung transparenten Material, die zwischen der aktiven Schicht (23) und der zweiten Klebeunterschicht (25) angeordnet ist.

13. Optoelektronische Vorrichtung (1) nach Anspruch 12, wobei die erste Klebeunterschicht (17) und/oder die zweite Klebeunterschicht (25) eine derartige Dickenstrukturierung aufweisen, dass die von den zusammengefügten Klebeunterschichten (17, 25) gebildete metallische Zwischenschicht (30) mindestens ein periodisches Gitter (32) aufweist und eine Mindestdicke (eₘᵢₙ) ungleich Null hat, wobei das periodische Gitter (32) von derartigen geometrischen Parametern (p, φ) definiert wird, dass die metallische Zwischenschicht (30) einen Übertragungskoeffizienten (T) der Anregungslichtstrahlung eines höheren Werts als ein Wert entsprechend einer äquivalenten metallischen Zwischenschicht (30) ohne periodisches Gitter, eben und mit einer konstanten Dicke gleich der Mindestdicke (eₘᵢₙ), aufweist.

## Claims

1. Process for fabricating an optoelectronic device (1) for emitting infrared light radiation, comprising the following steps:
i) producing a first stack (10) comprising:
• a light source (11) of exciting light radiation,
• a first bonding sublayer (17) made from a metal of interest chosen from gold, titanium and copper, having a first contact face (17a),
• between which is placed a first binding layer (16) made from a material that is transparent to the exciting light radiation;
ii) producing a second stack (20) comprising:
• a GeSn-based active layer (23) suitable for absorbing the exciting light radiation and for emitting in response the infrared light radiation, having an atomic proportion of tin (x_{Sn}) such that it has a direct electronic-band structure, and being obtained by epitaxial growth at an epitaxy temperature (Tₑₚᵢ),
• a second bonding sublayer (25) made from said metal of interest, having a second contact face (25a),
• between which is placed a second binding layer (24) made from a material that is transparent to the exciting light radiation;
iii) determining an assembly temperature (T_{c}) comprised between an ambient temperature (T_{amb}) and said epitaxy temperature (Tₑₚᵢ), to within 10%, such that a direct bonding energy per unit area of said metal of interest is higher than or equal to 0.5 J/m²;
iv) joining, by direct bonding, at said assembly temperature (T_{c}), said stacks (10, 20) via said contact faces (17a, 25a).

2. Fabricating process according to Claim 1, comprising:
- a phase of structuring the first bonding sublayer (17) and/or the second bonding sublayer (25) thicknesswise, so that the metal intermediate layer (30) formed by said bonding sublayers (17, 25) when joined to each other comprises at least one periodic grating (32), the metal intermediate layer (30) having a nonzero minimum thickness (eₘᵢₙ);
- a phase of determining, prior to the structuring phase, geometric parameters (p, ϕ) of the periodic grating (32), so that the metal intermediate layer (30) has a coefficient of transmission (T) of the exciting light radiation of a value higher than a preset value corresponding to an equivalent planar metal intermediate layer (30) without periodic grating and of a constant thickness equal to said minimum thickness (eₘᵢₙ).

3. Fabricating process according to Claim 2, wherein the periodic grating (32) is located at the interface with the first and/or second binding layers (16, 24), said contact faces (17a, 25a) being planar.

4. Fabricating process according to Claim 2 or 3, wherein the metal intermediate layer (30) comprises at least one continuous portion (31) of a constant first thickness equal to the minimum thickness (eₘᵢₙ) and pads (33) arranged to protrude with respect to the continuous portion (31) and forming the periodic grating (32).

5. Fabricating process according to any one of Claims 1 to 4, the exciting light source (11) being a light-emitting diode or a vertical-cavity-surface-emitting-laser source.

6. Fabricating process according to any one of Claims 1 to 5, wherein the exciting light source (11) is a vertical-cavity-surface-emitting-laser source comprising a lower reflector (13) and an upper reflector (15) between which a gain medium (14) is placed, the upper reflector (15) making contact with and being covered by the first binding layer (16), the process comprising:
- a phase of determining, prior to the phase of producing the first stack (10), a thickness (d) of the first binding layer (16), so that an equivalent reflector (M_{eq}) formed by the upper reflector (15) and by the metal intermediate layer (30), separated from each other by the first binding layer (16), has a coefficient of reflection (R) of the exciting light radiation of a value higher than a preset value.

7. Fabricating process according to any one of Claims 1 to 6, wherein the assembly temperature (T_{c}) is lower than or equal to the epitaxy temperature (Tₑₚᵢ) to within 10%.

8. Fabricating process according to any one of Claims 1 to 7, wherein the transparent material of the binding layers (16, 24) is a dielectric.

9. Fabricating process according to any one of Claims 1 to 8, wherein the transparent material of the binding layers (16, 24) is silicon-based.

10. Fabricating process according to any one of Claims 1 to 9, wherein the two bonding sublayers (17, 25) when joined to each other form a metal intermediate layer (30) having an average thickness comprised between 5 nm and 40 nm.

11. Fabricating process according to any one of Claims 1 to 10, comprising a step of structuring the GeSn-based active layer (23) so as to form a resonant cavity oriented in the plane of the active layer (23).

12. Optoelectronic device (1) for emitting infrared light radiation, comprising a stack of:
- a light source (11) of exciting light radiation;
- a first bonding sublayer (17) made from a metal of interest chosen from gold, titanium and copper, having a first contact face (17a);
- a first binding layer (16) made from a material that is transparent to the exciting light radiation, which layer is placed between the light source (11) and the first bonding sublayer (17);
- a second bonding sublayer (25) made from said metal of interest, having a second contact face (25a) joined to and making contact with the first contact face (17a);
- a GeSn-based active layer (23) having an atomic proportion of tin (x_{Sn}) such that it has a direct electronic-band structure, and suitable for absorbing the exciting light radiation and for emitting in response the infrared light radiation;
- a second binding layer (24) made from a material that is transparent to the exciting light radiation, which layer is placed between the active layer (23) and the second bonding sublayer (25).

13. Optoelectronic device (1) according to Claim 12, wherein the first bonding sublayer (17) and/or the second bonding sublayer (25) are structured thicknesswise so that the metal intermediate layer (30), formed by said bonding sublayers (17, 25) when joined to each other, comprises at least one periodic grating (32) and has a nonzero minimum thickness (eₘᵢₙ), the periodic grating (32) being defined by geometric parameters (p, ϕ) such that the metal intermediate layer (30) has a coefficient of transmission (T) of the exciting light radiation of a value higher than a value corresponding to an equivalent planar metal intermediate layer (30) without periodic grating and of a constant thickness equal to said minimum thickness (eₘᵢₙ).
